# FASCICULE DE BREVET EUROPEEN

(11) **EP 3 545 622 B1**
(45) Date de publication et mention de la délivrance du brevet: **07.07.2021**
(21) Numéro de dépôt: 17811650.5
(22) Date de dépôt: 22.11.2017
(51) Int. Cl.: H03K 17/10, H03K 17/16, H03K 17/22

(54) **DISPOSITIF DE COMMUTATION D'UN CIRCUIT DE PUISSANCE PRESENTANT UN CIRCUIT DE PROTECTION**
LEISTUNGSSCHALTVORRICHTUNG MIT EINER PASSIVEN SCHUTZSCHALTUNG
POWER CIRCUIT SWITCHING DEVICE HAVING A PASSIVE PROTECTION CIRCUIT

(30) Priorité: 25.11.2016 FR 1661531
(43) Date de publication de la demande: 02.10.2019
(73) Titulaire: Exagan, 38040 Grenoble Cedex 9 (FR)
(72) Inventeur: GUILLOT, Laurent, 31600 Seysses (FR); SUTTO, Thierry, 31600 Seysses (FR); MOREAU, Eric, 31470 Frouzins (FR)
(74) Mandataire: IP Trust
(86) Numéro de dépôt international: PCT/FR2017/053206
(87) Numéro de publication internationale: WO 2018/096263

(56) Documents cités:
- EP-A1- 3 001 563
- DE-B3-102011 083 684
- US-A1- 2015 171 750
- US-A1- 2016 308 444

## Description

### DOMAINE DE L'INVENTION

La présente invention concerne un dispositif de commutation d'un circuit de puissance à double commande.

### ARRIERE PLAN TECHNOLOGIQUE DE L'INVENTION

On connaît un tel dispositif du document « A dual-mode Driver IC with Monolithic Negative Drive-Voltage Capability and Digigtal Current-Mode Controller for Depletion-Mode GaN HEMT », Yue Wen et Al, IEEE Transaction on Power Electronic, 2016. Il comprend deux bornes de commutations permettant de sélectivement fournir de l'énergie à un circuit de puissance connecté à ses bornes. Le dispositif comprend également une première bonne pour recevoir un signal de commutation électriquement reliée, par un l'intermédiaire d'un circuit d'attaque, à la grille d'un transistor haute tension en mode déplétion.

L'état bloquant du transistor haute tension en mode déplétion est obtenu en appliquant une tension négative, inférieure à sa tension seuil, entre la grille et la source de ce transistor. Cette tension négative pouvant ne pas être disponible, par exemple au démarrage du dispositif de commutation ou lorsqu'il fonctionne en mode dégradé, le dispositif est muni d'un transistor basse tension en mode enrichissement, monté en série avec le transistor haute tension. En contrôlant séparément, en « double commande » chacun des transistors haute et basse tension mis en série, on contrôle précisément l'état ouvert ou fermé du circuit de commutationPlus précisément, le dispositif de commutation de l'état de la technique comprend une deuxième borne pour recevoir un signal de commande, la deuxième borne étant électriquement reliée à la grille du transistor basse tension. Le signal de commande permet donc de rendre bloquant le transistor basse tension et de contrôler l'état ouvert du dispositif de commutation, même en l'absence d'une tension négative appliquée à la grille du transistor haute tension.

Le dispositif de commutation peut présenter un mode de fonctionnement « actif » qui correspond au mode de fonctionnement « normal » dans lequel l'état ouvert ou fermé du dispositif est contrôlé par le signal de commutation. Il peut également présenter un mode de fonctionnement « inactif » qui correspond au mode « basse consommation » ou de mise en service du dispositif.

Dans ce dernier mode, le dispositif de commutation est à l'état ouvert et les différents éléments actifs du dispositif ne sont pas alimentés électriquement. C'est le cas notamment du circuit d'attaque de la grille du transistor haute tension. En l'absence d'alimentation électrique, ce circuit présente une sortie en haute impédance, la tension qui s'applique sur la grille du transistor haute tension est alors flottante et non contrôlée. Une éventuelle surtension s'appliquant sur le drain du transistor haute tension peut alors, par effet de couplage entre le drain et la grille, maintenir ou rendre le transistor haute tension passant malgré la désactivation du dispositif de commutation. Dans ce cas, toute la tension commutée s'applique aux bornes du transistor basse tension. Cette tension peut être importante, par exemple supérieur à 600 V, et excéder la tension d'avalanche que peut supporter ce transistor.

Pour prévenir ce problème, le document US20150171750 propose de placer une diode entre la grille du transistor haute tension et la masse du dispositif. Cette diode a pour effet de limiter la tension de grille du transistor haute tension à une tension sensiblement équivalente à la masse du dispositif (plus précisément à la tension seuil de la diode).

Dans le document cité, le circuit d'attaque est électriquement relié à la source du transistor haute tension. La tension de grille Vg du transistor haute tension étant essentiellement maintenue nulle, l'état passant ou bloquant de ce transistor est donc contrôlé en appliquant à la source, la tension Vs permettant d'imposer une tension Vgs entre la grille et la source qui soit supérieure ou inférieure à la tension de seuil de ce transistor. Plus précisément, le transistor haute tension en mode déplétion est fermé en appliquant une différence de tension nulle entre sa grille et sa source. Cette différence de tension, bien que supérieure à la tension seuil, et donc suffisante pour fermer le transistor, conduit à établir une résistance drain-source notable. On sait en effet que la résistance drain-source d'un tel transistor haute tension est d'autant plus faible que la tension grille-source, vis-à-vis de la tension seuil, est importante. Une résistance drain-source importante est très néfaste à l'efficacité énergétique du dispositif lorsqu'il conduit des courants de fortes intensités.

Par ailleurs, et quel que soit la solution choisie pour prévenir l'état passant intempestif du transistor haute tension, le passage d'un mode de fonctionnement normal à un mode de fonctionnement inactif du dispositif de commutation peut entrainer l'apparition de tensions transitoires ou la circulation de courants transitoires entre ses bornes. Ces tensions ou ces courants sont susceptibles d'endommager le transistor haute tension ou le transistor basse tension, si le passage d'un mode de fonctionnement à un autre n'est pas parfaitement contrôlé.

La présente invention vise à remédier, au moins en partie, l'un au moins des problèmes évoqués. Elle vise notamment à fournir un dispositif de commutation à double commande qui puisse être placé et maintenu dans un mode inactif en toute sécurité.

### BREVE DESCRIPTION DE L'INVENTION

En vue de la réalisation de l'un de ce but, l'objet de l'invention propose, dans son acceptation la plus large un dispositif de commutation d'un circuit de puissance comprenant deux bornes de commutation, un transistor haute tension en mode déplétion et un transistor basse tension en mode enrichissement, la tension d'avalanche du transistor basse tension étant inférieure à la tension d'avalanche du transistor haute tension, et disposés en série entre les deux bornes de commutation, une première borne pour recevoir un signal de commutation électriquement reliée par l'intermédiaire d'un circuit d'attaque à la grille du transistor haute tension et une seconde borne pour recevoir un signal de commande, électriquement reliée à la grille du transistor basse tension.

Selon l'invention, le dispositif de commutation comprend un circuit de protection électriquement relié entre la seconde borne et la grille du transistor haute tension pour placer la tension de grille du transistor haute tension à une valeur assurant le blocage du transistor haute tension lorsque le dispositif de commutation est dans un mode inactif dans lequel il n'est pas alimenté électriquement.

Selon d'autres caractéristiques avantageuses et non limitatives de l'invention, prises seules ou selon toute combinaison techniquement réalisable :
- le circuit passif de protection comprend un transistor bipolaire et une résistance placée dans l'émetteur du transistor bipolaire ;
- la base du transistor bipolaire est électriquement reliée à la seconde borne, le collecteur du transistor bipolaire est électriquement relié à la masse du dispositif et la résistance électriquement reliée à la grille du transistor haute tension ;
- le circuit de protection comprend une seconde résistance entre la seconde borne et la masse du dispositif ;
- la source du transistor haute tension est électriquement reliée au drain du transistor basse tension ;
- le transistor haute tension est un transistor HEMT à base de GaN ou de SiC ;
- le transistor basse tension est un transistor MOSFET à base de silicium ;
- la tension d'avalanche du transistor haute tension est supérieure à 600V ;
- Le dispositif comprend également un dispositif de commande électriquement relié à la première borne et à la deuxième borne pour élaborer le signal de commande et sélectivement transmettre le signal de commutation ;
- le circuit d'attaque est alimenté électriquement par au moins une source de tension d'alimentation ;
- le dispositif de commande est électriquement relié à au moins une source de tension d'alimentation pour sélectivement la mettre en fonctionnement ou l'éteindre.

### BREVE DESCRIPTION DES DESSINS

D'autres caractéristiques et avantages de l'invention ressortiront de la description détaillée de l'invention qui va suivre en référence aux figures annexées sur lesquels :
- La figure 1 représente un dispositif de commutation conforme à l'invention ;
- la figure 2 représente le schéma de transition entre un mode actif et un mode inactif d'un dispositif de commutation conforme à l'invention;
- la figure 3 représente un exemple particulier de mise en œuvre de l'invention.

### DESCRIPTION DETAILLEE DE L'INVENTION

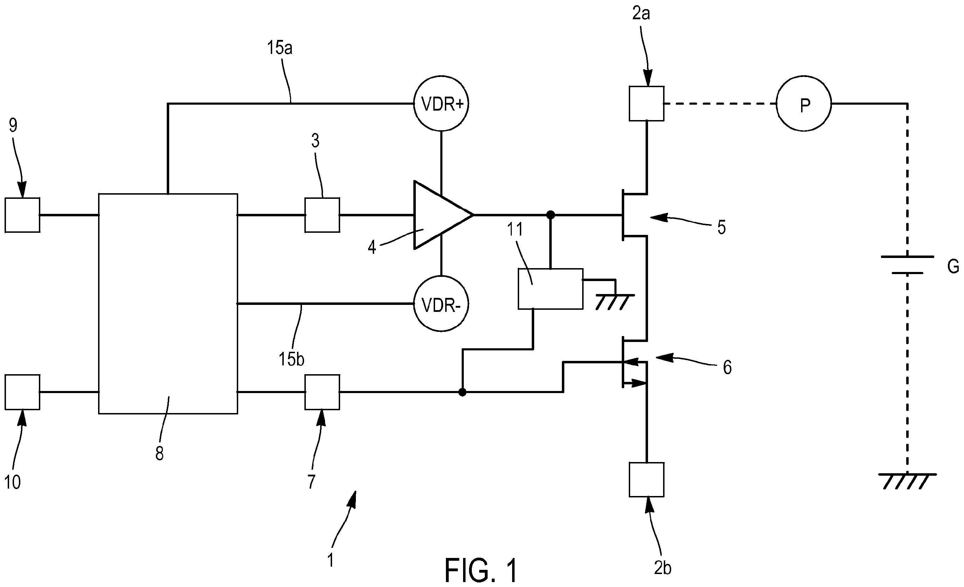

La figure 1 représente un dispositif de commutation 1 conforme à l'invention. On a représenté en pointillés sur cette figure une charge P et d'un générateur G composant un circuit de puissance connecté à deux bornes de commutation 2a, 2b du dispositif 1.

Le générateur G peut présenter une tension importante, par exemple de 600 V ou plus, et le courant circulant dans le circuit de puissance et dans le dispositif de commutation 1 peut être de forte intensité, par exemple supérieur à 1 A. Le dispositif de commutation 1, comme cela est bien connu en soi, permet de sélectivement appliquer la tension du générateur G à la charge P. Il agit donc comme un interrupteur de puissance, commandé par un signal de commutation de relativement faible amplitude, de l'ordre de quelques volts.

Le dispositif de commutation 1 comprend une première borne 3 pour recevoir ce signal de commutation. Cette première borne 3 est électriquement reliée par l'intermédiaire d'un circuit d'attaque 4 à une grille d'un transistor haute tension en mode déplétion 5.

Par « transistor haute tension », on désigne un transistor comprenant un drain, une source et une grille, la tension de faible amplitude appliquée sur la grille (de l'ordre de quelques volts) permettant de rendre électriquement passant ou bloquant la liaison entre le drain et la source. À l'état bloqué, la tension se développant entre le drain et la source peut être de forte amplitude, par exemple de 600 V ou plus, sans endommager le transistor.

Un transistor en mode déplétion présente une tension seuil négative (typiquement comprise entre -5V et -2V). La tension entre la grille et la source doit donc être négative, inférieure à cette tension seuil, pour rendre bloquant ce transistor.

Le transistor à haute tension en mode enrichissement peut être un transistor HEMT par exemple à base de GaN ou de SiC. Ce type de transistor présente une tension d'avalanche (c'est à dire la tension maximale applicable entre le drain et la source du transistor sans qu'il soit endommagé, il peut s'agir d'une tension de claquage) de forte amplitude, choisie pour être supérieure à la tension du générateur du circuit de puissance, par exemple de plus de 600V.

En fonctionnement normal du dispositif de commutation, la source du transistor haute tension est à 0 V. Pour permettre la commande du transistor haute tension à l'état bloquant ou à l'état passant selon la nature du signal de commutation, le circuit d'attaque 4 est relié à une première source de tension VDR+ et à une seconde source de tension VDR-• Le circuit d'attaque est alimenté avec une première tension, issue de la première source VDR+, dont la grandeur est supérieure à la tension de seuil du transistor haute tension. Il peut par exemple s'agir d'une tension de 2 V. Le circuit d'attaque est également alimenté avec une deuxième tension, issue de la deuxième source VDR-, dont la grandeur est inférieure à la tension de seuil du transistor haute tension. Il peut s'agir par exemple d'une tension de -8 V. Selon la valeur du signal de commutation appliquée à la première borne d'entrée 3, la première tension ou la deuxième tension est appliquée à la grille du transistor haute tension permettant sélectivement de le rendre passant ou bloquant.

Poursuivant la description du dispositif de commutation 1 de la figure 1, le transistor haute tension 5 est disposé en série avec un transistor basse tension 6 entre les deux bornes de commutations 2a, 2b. En d'autres termes, le drain du transistor haute tension 5 est électriquement relié à une des deux bornes de commutation 2a, 2b, la source du transistor haute tension 5 est reliée au drain du transistor basse tension 6, et la source du transistor basse tension 6 est reliée à l'autre des deux bornes de commutations 2a, 2b.

Un transistor en mode enrichissement présente une tension seuil positive. La tension entre la grille et la source doit donc être positive et supérieure à cette tension seuil, pour rendre passant ce transistor.

Le transistor basse tension peut-être un transistor MOSFET à base de silicium. La tension d'avalanche du transistor basse tension est inférieure à celle du transistor haute tension. Elle peut être par exemple de l'ordre de 30 V.

Une seconde borne 7 du dispositif de commutation 1 est reliée à la grille du transistor basse tension 6. Cette seconde borne 7 est prévue pour recevoir un signal de commande.

Comme cela ressort du schéma de principe de la figure 1, un signal de commande positif et supérieur à la tension seuil du transistor basse tension appliquée sur la seconde borne 7, rend le transistor basse tension passant, la source du transistor basse tension étant reliée à la masse du circuit. Dans ce premier mode de fonctionnement (qui correspond à l'état de fonctionnement actif normal du dispositif 1), l'état ouvert ou fermé du dispositif de commutation 1 est dicté par le signal de commutation appliquée sur la première borne 3.

Au contraire, lorsque le signal de commande présentant une tension inférieure à la tension seuil du transistor basse tension est appliqué sur la seconde borne 7, le transistor basse tension est placé dans un mode bloqué. Dans ce mode de fonctionnement, le dispositif de commutation 1 est à l'état ouvert, quelle que soit la valeur du signal de commutation appliquée sur la première borne d'entrée 3. On rappelle que lorsque le dispositif 1 est dans cet état ouvert, le signal de commande présentant une tension inférieure à la tension seuil du transistor basse tension, le drain de ce transistor présente une tension flottante qui, tirée par le courant de fuite du transistor haute tension, s'établit à la tension d'avalanche du transistor basse tension, qui comme on l'a mentionné précédemment peut être de 30V.

Le dispositif de commutation 1 comprend également un circuit de commande 8 pour élaborer le signal de commande et/ou transmettre le signal de commutation, selon le mode de fonctionnement actif ou inactif du dispositif de commutation 1. Le circuit de commande 8 comprend deux sorties, respectivement connectées électriquement à la première borne 3 et à la seconde borne 7. Le circuit de commande comprend également une première entrée 9 pour recevoir le signal de commutation et une seconde entrée 10 pour recevoir un signal d'activation du dispositif 1.

Pour permettre au circuit de commande 8 de commander la mise en fonctionnement, l'extinction et vérifier le bon fonctionnement des sources de tension VDR+, VDR-, le circuit de commande 8 est relié à ces sources d'alimentation électrique par des liaisons électriques 15a, 15b.

Selon un aspect de l'invention, le circuit de commande 8 forme une machine d'état permettant de placer le dispositif dans l'un des modes de fonctionnement du dispositif 1 et de contrôler la transition entre ces modes en toute sécurité, comme cela est décrit dans les paragraphes qui suivent. Le circuit de commande 8 peut être réalisé sous forme intégrée, par exemple sous la forme d'un système de portes logiques programmable ou sous la forme de composants discrets, voire même sous la forme d'un microcontrôleur convenablement programmé pour reproduire le comportement détaillé ci-dessous.

Le circuit de commande 8 est électriquement relié aux grilles des transistors haute tension et basse tension pour commander l'état bloqué ou passant de ces transistors, notamment lors du passage d'un mode de fonctionnement à un autre du dispositif. En contrôlant individuellement et directement les grilles des transistors, on peut se prémunir des effets transitoires qui pourraient se développer et endommager l'un des transistors. On peut également de la sorte se prémunir d'un fonctionnement non sécurisé du dispositif.

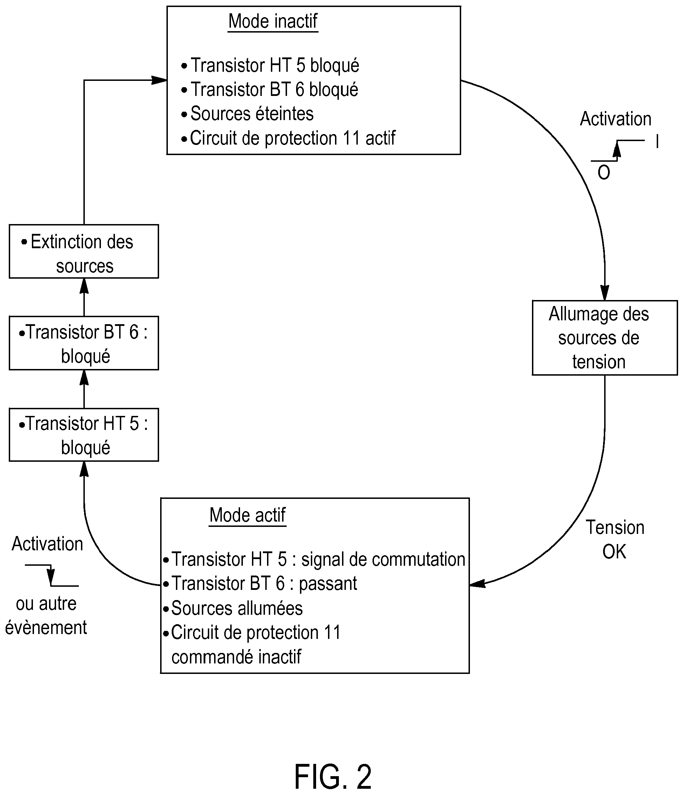

Comme cela est schématiquement représenté par le modèle de transition de la figure 2, le mode de fonctionnement du dispositif 1 est déterminé par le niveau d'un signal d'activation appliqué à la deuxième entrée 10 du circuit de commande 8.

Lorsque ce signal d'activation présente un premier niveau (par exemple de 5 V), le dispositif de commutation 1 est commandé en fonctionnement normal, c'est-à-dire actif. Dans ce mode de fonctionnement, le circuit de commande 8 applique sur la deuxième borne 7 un signal de commande présentant une tension supérieure à la tension seuil du transistor basse tension de manière à le rendre passant. Dans le même temps, le circuit de commande transmet le signal de commutation, qui est appliqué à la deuxième entrée du circuit de commande 8, à la première borne 3, de sorte à piloter en commutation le transistor haute tension 5. Dans ce mode de fonctionnement, les sources VDR+, VDR- de tension d'alimentation électrique des éléments actifs du dispositif sont commandé par le circuit de commande 8 pour être en fonctionnement, c'est à dire pour qu'elles délivrent une première et une seconde tension égale, à 10% près, à leurs tensions de consigne. Dans ce mode de fonctionnement également, un circuit de protection 11 (dont la description sera détaillée dans une section ultérieure de cette demande) est inactif, c'est-à-dire qu'il est commandé pour être ouvert.

Lorsque le signal d'activation présente un second niveau, différent du premier (par exemple 0 V), le dispositif 1 est en fonctionnement « stand-by », c'est-à-dire qu'il est inactif. Dans ce mode de fonctionnement, le circuit de commande 8 applique sur la deuxième borne 7 un signal de commande présentant une tension inférieure à la tension seuil du transistor basse tension 6 de manière à le rendre bloquant. Dans le même temps, le circuit de commande 8 applique une tension nulle ou suffisamment faible à la première borne 3 de sorte à rendre bloquant, via le circuit d'attaque 4, le transistor haute tension 5. Dans ce mode également, les sources de tension assurant l'alimentation électrique des éléments actifs du dispositif, et notamment l'alimentation du circuit d'attaque 4, sont commandées par le circuit de commande 8 pour être éteintes.

L'activation du dispositif de commutation 1, c'est-à-dire le passage du mode inactif au mode actif, est détectée par le circuit de commande 8 sur un front montant du signal d'activation. Sur ce front montant, le circuit de commande 8 enclenche l'établissement des sources de tension assurant l'alimentation des éléments actifs du dispositif. Lorsque celles-ci sont bien établies, le circuit de commande place le dispositif 1 en mode normal de fonctionnement tel que cela a été décrit précédemment. Si ces tensions ne peuvent s'établir correctement, le circuit de commande 8 maintient le dispositif 1 en mode inactif, c'est-à-dire que le transistor haute tension et le transistor basse tension sont tous deux commandés pour présenter un état bloqué. Le circuit de commande 8 signale éventuellement ce dysfonctionnement par l'intermédiaire d'un signal additionnel (et non représenté sur la figure 1).

Par « établir correctement les sources de tension », on signifie que celles-ci délivrent une tension égale à 10% près leurs tensions de consigne. Le circuit de commande 8 est relié aux sources VDR+, VDR- par l'intermédiaire des liaisons 15a, 15b, ce qui lui permet de recevoir les tensions effectivement délivrées par ces sources et de les comparer aux tensions de consignes. Le circuit de commande 8 est ainsi apte à détecter leur bon état de fonctionnement.

La désactivation du dispositif de commutation 1, c'est-à-dire le passage du mode actif au mode inactif, est détectée par le circuit de commande 8 sur un front descendant du signal d'activation. Sur ce front descendant, le circuit de commande enclenche dans une première étape l'application d'une tension nulle ou suffisamment faible sur la première borne 3 pour rendre bloquant le transistor haute tension 5, via le circuit d'attaque 4. Puis, dans une seconde étape, le circuit de commande 8 applique sur la deuxième borne 7 une tension conduisant à rendre le transistor basse tension bloquant. Le circuit de commande 8 commande alors l'extinction des sources de tension assurant l'alimentation des éléments actifs du dispositif 1, notamment les sources VDR+, VDR- du circuit d'attaque 4, et donc les tensions délivrées par ces sources ne peuvent plus être garanties.

La désactivation du dispositif de commutation 1 peut être provoquée par d'autres évènements qu'un front descendant du signal d'activation. Il peut par exemple s'agir d'un évènement indiquant une défaillance ou d'un événement susceptible de provoquer une défaillance du dispositif de commutation. A titre d'exemple, si, lorsque le dispositif 1 de commutation est en mode actif, le circuit de commande 8 détecte que la première tension et/ou la deuxième tension délivrée par les sources de tensions VDR+, VDR- au circuit d'attaque 4 s'écartent à plus de 10% de leurs valeurs de consigne, il peut provoquer le passage à l'état inactif du dispositif 1.

Comme on l'a vu en préambule de cette demande, dans le mode inactif, la grille du transistor haute tension présente une tension flottante, qui peut être affectée, par effet de couplage, par la tension se développant sur le drain du transistor haute tension 5. Ce transistor peut de manière non contrôlée passer alors d'un état bloqué à un état passant, ce qui peut endommager le dispositif de commutation 1, et notamment le transistor basse tension 6.

Afin de prévenir ce phénomène, le dispositif de commutation 1 comprend, selon un autre aspect de l'invention, un circuit de protection 11 normalement passant et électriquement relié entre la seconde borne 7 et la grille du transistor haute tension 5.

Le circuit de protection 11 a pour fonction de rendre et maintenir bloquant le transistor haute tension 5 lorsque le circuit d'attaque n'est pas électriquement alimenté. Le circuit protection 11 est normalement passant, il ne nécessite pas d'être électriquement alimenté pour assurer sa fonction, et il peut fonctionner même en l'absence des tensions d'alimentation du dispositif, lorsque celui-ci est désactivé. Lorsque le dispositif de commutation est en mode de fonctionnement actif, le circuit de protection est commandé pour être désactivé. Il constitue donc un circuit de protection à sécurité intégré (« fail safe » selon la terminologie anglo-saxonne usuellement employée).

Lorsque le dispositif de commutation 1 est inactif, la sortie du circuit d'attaque 4 présente une haute impédance. La tension de grille du transistor haute tension 5 est donc flottante et non contrôlée. Le circuit de protection vise donc à placer cette tension à une valeur déterminée, assurant le blocage du transistor haute tension 5. On évite de la sorte d'appliquer toute la tension du générateur G aux bornes du transistor basse tension 6, ce qui pourrait l'endommager.

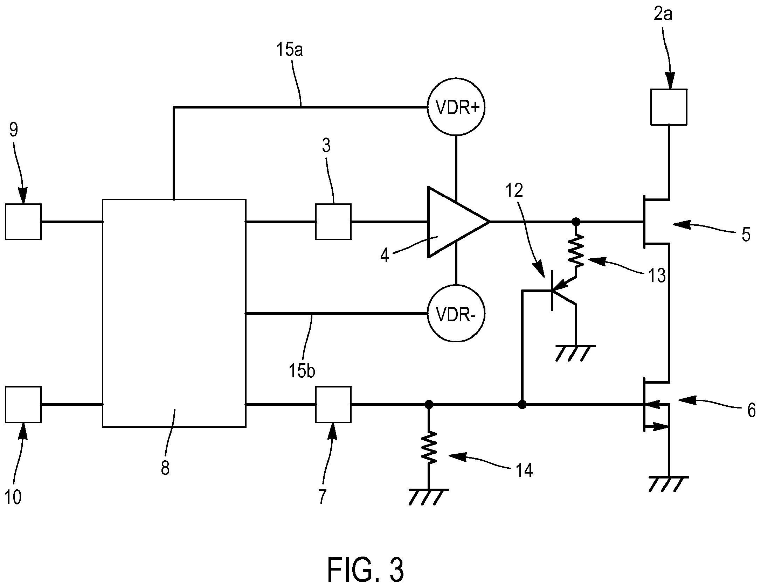

La figure 3 présente un exemple particulier de mise en œuvre de cet aspect de l'invention. On reconnaît sur cette figure les deux bornes de commutation 2a, 2b, le transistor haute tension 5, le transistor basse tension 6, le circuit d'attaque 4, le circuit de commande 8 et les deux bornes 3, 7 déjà décrits en relation avec la description générale de l'invention.

Le circuit de protection 11 est formé d'un transistor bipolaire PNP 12 et d'une résistance 13 placée dans l'émetteur du transistor bipolaire 12.

La base du transistor bipolaire 12 est électriquement reliée à la seconde borne 7. Le collecteur est placé à la masse du dispositif et la résistance électrique 13 connectée à la grille du transistor haute tension 5.

Le circuit de protection comprend en outre, entre la seconde borne d'entrée 7 et la masse du dispositif, une seconde résistance 14.

Lorsque le signal de commande du dispositif 1 est supérieur à la tension seuil du transistor basse tension, et donc lorsque le dispositif de commutation 1 est en fonctionnement actif, le transistor bipolaire 12 est ouvert et le circuit de protection 11 n'a aucune influence sur le fonctionnement du transistor haute tension 5 et donc du dispositif de commutation 1 dans son ensemble.

Plus précisément, cette condition est respectée lorsque la tension de la base du transistor bipolaire 12 est supérieure à la tension de son émetteur. La tension de la base correspond à la commande de la grille du transistor basse tension 6. La tension de l'émetteur est alternativement égale à la première et à la seconde tension délivrée par les sources de tension VDR+, VDR- du circuit d'attaque. Pour qu'effectivement le transistor bipolaire 12 soit ouvert en fonctionnement normal du dispositif, on choisit la tension de commande du transistor basse tension pour qu'elle soit supérieure à la première tension délivrée par la source de tension VDR+ du circuit d'attaque 4.

Lorsqu'au contraire, le signal de commande du dispositif de commutation 1 est inférieur à la tension seuil du transistor basse tension 6, et donc lorsque le dispositif de commutation est en mode inactif, le transistor bipolaire 12 est fermé sur la première résistance 13 placée à la masse. Le circuit qui se forme alors conduit à placer la tension de grille du transistor haute tension à une tension proche de 0 V. La source du transistor haute tension est placée, lorsque le transistor basse tension est en mode bloqué, sensiblement à la tension d'avalanche de ce transistor basse tension (qui peut être de l'ordre de 30V). On applique donc une tension entre la grille et la source du transistor haute tension qui est sous sa tension seuil, assurant son état bloquant avec certitude.

Bien entendu l'invention n'est pas limitée au mode de mise en œuvre décrit et on peut y apporter des variantes de réalisation sans sortir du cadre de l'invention tel que défini par les revendications.

Ainsi, bien que l'on ait présenté un dispositif de commutation combinant un circuit de protection associé à un circuit de commande, chacun de ces éléments peut être exploité séparément dans des dispositifs de commutation présentant une architecture différente de celle qui vient d'être décrite.

Pour lever toute ambiguïté, les termes « électriquement connecté » ou « électriquement relié » de la présente description sont utilisés pour indiquer que deux éléments sont directement ou indirectement connectés entre eux.

## Revendications

1. Dispositif de commutation (1) d'un circuit de puissance comprenant :
- deux bornes de commutation (2a, 2b);
- un transistor haute tension en mode déplétion (5) et un transistor basse tension en mode enrichissement (6) disposés en série entre les deux bornes de commutation (2a, 2b), la tension d'avalanche du transistor basse tension (6) étant inférieure à la tension d'avalanche du transistor haute tension (5) ;
- une première borne (3) pour recevoir un signal de commutation,
- un circuit d'attaque (4), connecté électriquement entre la première borne et la grille du transistor haute tension (5);
- une seconde borne (7) pour recevoir un signal de commande, électriquement reliée à la grille du transistor basse tension (6) ;
le dispositif comprenant un circuit de protection (11) électriquement relié entre la seconde borne (7) et la grille du transistor haute tension (5) **caractérisé en ce que** le circuit de protection est configuré
pour placer la tension de grille du transistor haute tension (5) à une valeur assurant le blocage du transistor haute tension (5) lorsque le dispositif de commutation (1) est dans un état inactif dans lequel il n'est pas alimenté électriquement.

2. Dispositif de commutation selon la revendication précédente dans lequel le circuit de protection (11) comprend un transistor bipolaire (12) et une résistance (13) placée dans l'émetteur du transistor bipolaire (12).

3. Dispositif de commutation selon la revendication précédente dans lequel la base du transistor bipolaire (12) est électriquement reliée à la seconde borne (7), le collecteur du transistor bipolaire est électriquement relié à la masse du dispositif et la résistance électriquement reliée à la grille du transistor haute tension (5).

4. Dispositif de commutation selon l'une des revendications précédentes dans lequel le circuit de protection (11) comprend une seconde résistance (14) entre la seconde borne (7) et la masse du dispositif (1).

5. Dispositif de commutation selon l'une des revendications précédentes dans lequel la source du transistor haute tension (5) est électriquement reliée au drain du transistor basse tension (6).

6. Dispositif de commutation selon l'une des revendications précédentes dans lequel le transistor haute tension (5) est un transistor HEMT à base de GaN ou de SiC.

7. Dispositif de commutation selon l'une des revendications précédentes dans lequel le transistor basse tension (6) est un transistor MOSFET à base de silicium.

8. Dispositif de commutation selon l'une des revendications précédentes dans lequel la tension d'avalanche du transistor haute tension (5) est supérieure à 600V.

9. Dispositif de commutation selon l'une des revendications précédentes comprenant également un dispositif de commande (8) électriquement reliée à la première borne (3) et à la deuxième borne (7) pour élaborer le signal de commande et sélectivement transmettre le signal de commutation.

10. Dispositif de commutation selon l'une des revendications précédentes dans lequel le circuit d'attaque (4) est alimenté électriquement par au moins une source (VDR+, VDR-) de tension d'alimentation.

11. Dispositif de commutation selon la revendication précédente dans lequel le dispositif de commande (8) est électriquement relié à au moins une source de tension d'alimentation pour sélectivement la mettre en fonctionnement ou l'éteindre.

## Patentansprüche

1. Schaltvorrichtung (1) einer Leistungsschaltung, umfassend:
- zwei Schaltklemmen (2a, 2b);
- einen Hochspannungstransistor im Verarmungsmodus (5) und einen Niederspannungstransistor im Anreicherungsmodus (6), die in Reihe zwischen den zwei Schaltklemmen (2a, 2b) angeordnet sind, wobei die Lawinenspannung des Niederspannungstransistors (6) niedriger als die Lawinenspannung des Hochspannungstransistors (5) ist;
- eine erste Klemme (3) zum Empfangen eines Schaltsignals,
- eine Treiberschaltung (4), die zwischen der ersten Klemme und dem Gate des Hochspannungstransistors (5) elektrisch geschaltet ist;
- eine zweite Klemme (7) zum Empfangen eines Steuersignals, die mit dem Gate des Niederspannungstransistors (6) elektrisch verbunden ist;
wobei die Vorrichtung eine Schutzschaltung (11) umfasst, die zwischen der zweiten Klemme (7) und dem Gate des Hochspannungstransistors (5) elektrisch verbunden ist, **dadurch gekennzeichnet, dass** die Schutzschaltung ausgelegt ist, um die Gate-Spannung des Hochspannungstransistors (5) auf einen Wert einzustellen, der die Blockierung des Hochspannungstransistors (5) gewährleistet, wenn sich die Schaltvorrichtung (1) in einem inaktiven Zustand befindet, in dem sie nicht elektrisch versorgt wird.

2. Schaltvorrichtung nach vorhergehendem Anspruch, wobei die Schutzschaltung (11) einen Bipolartransistor (12) und einen Widerstand (13) umfasst, der im Sender des Bipolartransistors (12) angeordnet ist.

3. Schaltvorrichtung nach vorhergehendem Anspruch, wobei die Basis des Bipolartransistors (12) mit der zweiten Klemme (7) elektrisch verbunden ist, der Kollektor des Bipolartransistors mit der Masse der Vorrichtung elektrisch verbunden ist und der Widerstand mit dem Gate des Hochspannungstransistors (5) elektrisch verbunden ist.

4. Schaltvorrichtung nach einem der vorhergehenden Ansprüche, wobei die Schutzschaltung (11) einen zweiten Widerstand (14) zwischen der zweiten Klemme (7) und der Masse der Vorrichtung (1) umfasst.

5. Schaltvorrichtung nach einem der vorhergehenden Ansprüche, wobei die Quelle des Hochspannungstransistors (5) mit dem Drain des Niederspannungstransistors (6) elektrisch verbunden ist.

6. Schaltvorrichtung nach einem der vorhergehenden Ansprüche, wobei der Hochspannungstransistor (5) ein auf GaN oder SiC basierender HEMT-Transistor ist.

7. Schaltvorrichtung nach einem der vorhergehenden Ansprüche, wobei der Niederspannungstransistor (6) ein MOSFET-Transistor auf Siliziumbasis ist.

8. Schaltvorrichtung nach einem der vorhergehenden Ansprüche, wobei die Lawinenspannung des Hochspannungstransistors (5) über 600 V beträgt.

9. Schaltvorrichtung nach einem der vorhergehenden Ansprüche, umfassend ebenfalls eine Steuervorrichtung (8), die mit der ersten Klemme (3) und mit der zweiten Klemme (7) elektrisch verbunden ist, um das Steuersignal zu erzeugen und das Schaltsignal selektiv zu übertragen.

10. Schaltvorrichtung nach einem der vorhergehenden Ansprüche, wobei die Treiberschaltung (4) von mindestens einer Versorgungsspannungsquelle (VDR+, VDR-) elektrisch versorgt wird.

11. Schaltvorrichtung nach vorhergehendem Anspruch, wobei die Steuervorrichtung (8) mit mindestens einer Versorgungsspannungsquelle elektrisch verbunden ist, um sie selektiv ein- oder auszuschalten.

## Claims

1. Device (1) for switching a power circuit, comprising:
- two switching terminals (2a, 2b);
- a high voltage depletion-mode transistor (5) and a low voltage enhancement-mode transistor (6) which are arranged in series between the two switching terminals (2a, 2b), the avalanche voltage of the low voltage transistor (6) being lower than the avalanche voltage of the high voltage transistor (5);
- a first terminal (3) for receiving a switching signal;
- a driver circuit (4) which is electrically connected between the first terminal and the gate of the high voltage transistor (5); and
- a second terminal (7) which is intended for receiving a control signal and is electrically connected to the gate of the low voltage transistor (6);
the device comprising a protective circuit (11) which is electrically connected between the second terminal (7) and the gate of the high voltage transistor (5), **characterized in that** the protective circuit is designed to set the gate voltage of the high voltage transistor (5) to a value that can block the high voltage transistor (5) when the switching device (1) is in an inactive state in which it is not electrically powered.

2. Switching device according to the preceding claim, wherein the protective circuit (11) comprises a bipolar transistor (12) and a resistor (13) which is positioned in the emitter of the bipolar transistor (12).

3. Switching device according to the preceding claim, wherein the base of the bipolar transistor (12) is electrically connected to the second terminal (7), the collector of the bipolar transistor is electrically connected to the ground of the device, and the resistor is electrically connected to the gate of the high voltage transistor (5).

4. Switching device according to any of the preceding claims, wherein the protective circuit (11) comprises a second resistor (14) between the second terminal (7) and the ground of the device (1).

5. Switching device according to any of the preceding claims, wherein the source of the high voltage transistor (5) is electrically connected to the drain of the low voltage transistor (6).

6. Switching device according to any of the preceding claims, wherein the high voltage transistor (5) is a GaN- or SiC-based HEMT transistor.

7. Switching device according to any of the preceding claims, wherein the low voltage transistor (6) is a silicon-based MOSFET transistor.

8. Switching device according to any of the preceding claims, wherein the avalanche voltage of the high voltage transistor (5) is greater than 600 V.

9. Switching device according to any of the preceding claims, also comprising a control device (8) which is electrically connected to the first terminal (3) and to the second terminal (7) and is intended for producing the control signal and selectively transmitting the switching signal.

10. Switching device according to any of the preceding claims, wherein the driver circuit (4) is electrically powered by at least one supply voltage source (VDR+, VDR-).

11. Switching device according to the preceding claim, wherein the control device (8) is electrically connected to at least one supply voltage source in order to selectively turn said source on or off.
